# EUROPÄISCHE PATENTSCHRIFT

(11) **EP 2 244 156 B1**
(45) Veröffentlichungstag und Bekanntmachung des Hinweises auf die Patenterteilung: **02.08.2017**
(21) Anmeldenummer: 10159196.4
(22) Anmeldetag: 07.04.2010
(51) Int. Cl.: G06F 1/20, H05K 7/20

(54) **Systemeinheit für einen Rechner**
System unit for a computer
Unité de système pour un ordinateur

(30) Priorität: 20.04.2009 DE 102009018076
(43) Veröffentlichungstag der Anmeldung: 27.10.2010
(73) Patentinhaber: Siemens Aktiengesellschaft, 80333 München (DE)
(72) Erfinder: Berz, Arno, 76287 Rheinstetten (DE); Spuhler, Bernhard, 76877 Offenbach (DE)

(56) Entgegenhaltungen:
- EP-A1- 1 760 722

## Beschreibung

Die Erfindung betrifft eine Systemeinheit für einen Rechner, mit mindestens einer mit Bauelementen versehenen Steckkarte und mit einem Lüfter zur Kühlung der Bauelemente, wobei die Systemeinheit ferner mit einer Regelung zum Einstellen der Lüfterdrehzahl in Abhängigkeit von einem Signal eines Temperatursensors versehen ist.

Eine Systemeinheit eines Rechners ist aus dem Siemens-Katalog ST PC, Ausgabe 11/2008, Kapitel 3 bekannt. An diese Systemeinheit in Form eines so genannten "Rack PCs" sind eine Bedieneingabe-Einheit, z. B. eine Bedieneingabe-Einheit in Form einer Tastatur und/oder einer Maus, sowie mindestens ein Bildwiedergabegerät und sonstige Hardware-Einheiten anschließbar. Ferner ist diese Systemeinheit mit weiteren für den Betrieb des Rechners geeigneten, in Steckplätze eines so genannten Motherboards steckbaren PCI-Steckkarten sowie weiteren Hardwaremitteln versehen. Ein mittels eines Lüfters erzeugter Luftstrom ist für die Entwärmung der Steckkarten bzw. deren Bauelemente vorgesehen, wobei zur Erzeugung eines ausreichend dimensionierten Luftstroms im Innern der Systemeinheit eine Regelung in Abhängigkeit der erfassten Temperatur die Lüfterdrehzahl bzw. die Lüfterleistung entsprechend einstellt. Die bekannte Systemeinheit kann sowohl in einer waagrechten als auch in einer senkrechten Lage beispielsweise in einen Schaltschrank eingebaut oder mit einem geeigneten Montagezubehör als so genannter "Industrie Tower PC" aufgestellt werden.
Um unabhängig von der Lage der Systemeinheit eine gute Entwärmung zu ermöglichen, können beispielsweise mehrere Temperatursensoren vorgesehen werden, die jeweils an ihrem Einbauplatz in der Systemeinheit die jeweilige Temperatur erfassen und der Regelung zuführen. In Abhängigkeit der erfassten Maximaltemperatur stellt die Regelung die Drehzahl des Lüfters derart ein, dass der Luftstrom bzw. die Luftströme des Lüfters die Steckkarten bzw. deren Bauelemente ausreichend kühlen. Nachteilig ist, dass eine Vielzahl von Temperatursensoren erforderlich ist, die an unterschiedlichen im Innern der Systemeinheit geeigneten Positionen angeordnet werden müssen, um zu vermeiden, dass sich unerwünschte "Wärmenester" bilden.

Es ist auch möglich, nur einen einzigen Sensor einzusetzen und in Abhängigkeit der erfassten Temperatur dieses Sensors die Lüfterdrehzahl stets derart hoch einzustellen, dass auch bei thermisch ungünstiger Einbaulage die Entwärmung noch ausreichend ist. Dies bedeutet allerdings, dass bei dieser Temperatur sich diese Lüfterdrehzahl auch in einer thermisch guten Einbaulage einstellt, was einen erhöhten Strombedarf und erhöhten Geräuschpegel zur Folge hat.

Aus der EP 1 760 722 A1 ist eine Speicherplattenanordnung mit Speicherboxen bekannt, wobei in Abhängigkeit einer erfassten Temperatur und in Abhängigkeit einer Position der Speicherboxen die Drehzahl von Lüftern eingestellt wird.

Der vorliegenden Erfindung liegt die Aufgabe zugrunde, eine Systemeinheit für einen Rechner der eingangs genannten Art zu schaffen, mit welcher eine Kühlung von in dieser Systemeinheit angeordneten Steckkarten bzw. der auf dieser angeordneten oder in dieser integrierten Bauelemente verbessert wird.

Diese Aufgabe wird durch die im Patentanspruch angegebenen Maßnahmen gelöst.

Vorteilhaft ist, dass beispielsweise im Rahmen einer Werkseinstellung die Lüfterdrehzahl nicht mehr an die ungünstigste Lage der Systemeinheit angepasst werden muss, um sicherzustellen, dass unabhängig von der Lage der Systemeinheit vor Ort noch eine ausreichende Kühlung gegeben ist. Für den Fall, dass z. B. ein vertikaler Einbau der Systemeinheit in einen Schaltschrank thermisch ungünstig ist und die Systemeinheit allerdings horizontal eingebaut wird, reduziert die Regelung die Lüfterdrehzahl, wodurch der Strombedarf und der Geräuschpegel des Lüfters vermindert werden. Darüber hinaus wird aufgrund des horizontalen Einbaus und der damit verbundenen reduzierten Lüfterdrehzahl die Lebensdauer des Lüfters und der Systemeinheit verlängert.

Die Systemeinheit kann selbstverständlich auch für ein Automatisierungsgerät vorgesehen sein, welches mehrere Baugruppen zum Steuern eines technischen Prozesses umfasst. Dabei ist allgemein der Begriff "Automatisierungsgerät" so auszulegen, dass er sämtliche Geräte, Einrichtungen oder Systeme umfasst, also neben z. B. Steuerungen, wie speicherprogrammierbaren Steuerungen, Prozessrechnern, (Industrie-)Computern und dergleichen, auch Antriebssteuerungen, Frequenzumrichter und Ähnliches, wie sie zur Steuerung, Regelung und/oder Überwachung technischer Prozesse z. B. zum Umformen oder Transportieren von Material, Energie oder Information etc. eingesetzt werden oder einsetzbar sind, wobei insbesondere über geeignete technische Einrichtungen, wie z. B. Sensoren oder Aktoren, Energie aufgewandt oder gewandelt wird.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figur 1: eine perspektivische Darstellung einer Systemeinheit eines Rechners und
- Figur 2: eine Regelung zum Einstellen der Drehzahl eines Lüfters.

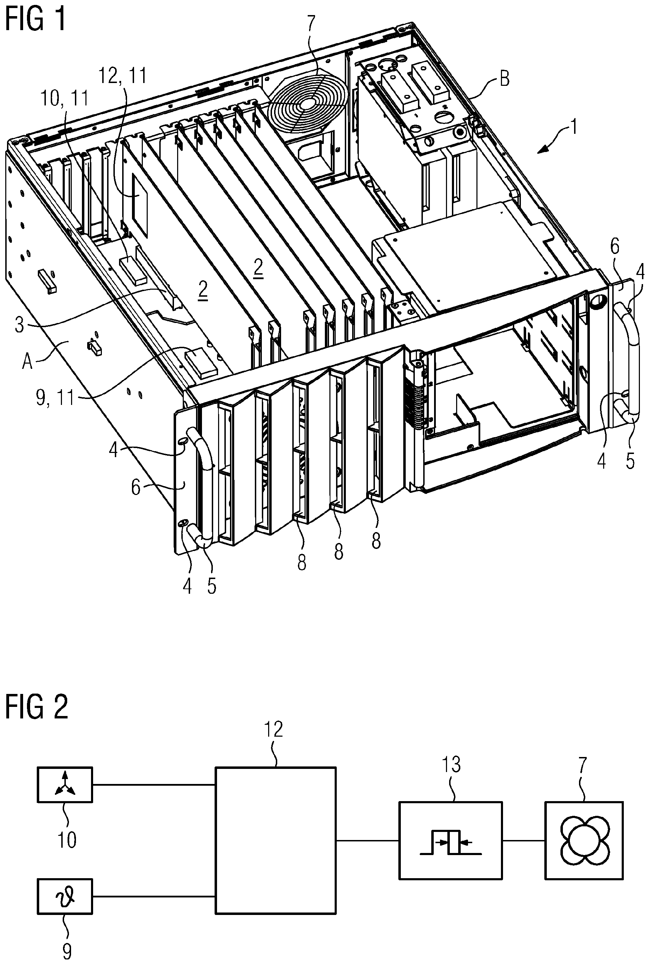

Die in den Figuren 1 und 2 dargestellten gleichen Teile sind mit gleichen Bezugszeichen versehen.

In Figur 1 ist mit 1 eine Systemeinheit eines Rechners bezeichnet, welche zur besseren Übersicht ohne Abdeckung und ohne eingebaute Disketten- oder Festplattenlaufwerke dargestellt ist. An diese Systemeinheit 1 sind Bedieneingabe-Einheiten, z. B. Bedieneingabe-Einheiten in Form einer Tastatur und/oder einer Maus, sowie mindestens ein Bildwiedergabegerät und weitere Hardware-Einheiten anschließbar. Die Systemeinheit 1 ist ferner mit so genannten PCI-Steckkarten 2 versehen, die in Steckplätze 3 eines Motherboards gesteckt sind. Selbstverständlich weist das Motherboard weitere Steckplätze zur Aufnahme weiterer Steckkarten auf, z. B. Steckkarten zur Verwirklichung einer Ethernet- oder Feldbuskommunikation. An der Frontseite der Systemeinheit 1 sind zwei mit Bohrungen 4 und Griffen 5 versehene Montagewinkel 6 angeordnet, mittels deren die Systemeinheit 1 z. B. in einen hier nicht dargestellten Schaltschrank entweder horizontal oder vertikal eingebaut werden kann. Weitere Bestandteile der Systemeinheit 1, wie beispielsweise Netzteil oder sonstige für den Betrieb des Rechners geeignete Hardwaremittel, sind für die Erfindung ohne Bedeutung und werden daher nicht erläutert.

Um insbesondere die Steckkarten 2 bzw. deren Bauelemente während des Rechnerbetriebs zu entwärmen, ist die Systemeinheit 1 mit einem Lüfter 7 versehen, welcher Kaltluft von außerhalb der Systemeinheit 1 ansaugt und einen Luftstrom in das Innere der Systemeinheit 1 bläst, wobei sich dieser Luftstrom aufgrund der durch die Bauelemente erzeugten Wärme während des Betriebs des Rechners erwärmt und über Öffnungen 8 der Systemeinheit 1 nach außen abgeführt wird.

Um sicherzustellen, dass der Lüfter 7 eine ausreichende Luftmenge zur Kühlung der Steckkarten 2 bzw. deren Bauelemente ansaugt, weist die Systemeinheit 1 eine mit einem Temperatursensor 9 und einem Lagesensor 10 versehene Lüfterdrehzahl-Regelung 11 auf. Diese Regelung 11 oder Teile dieser Regelung 11 können selbstverständlich auf einer Steckkarte 2 verwirklicht werden, wobei die Regelung 11 in Abhängigkeit der von dem Sensor 9 erfassten Temperatur im Innern der Systemeinheit 1 und in Abhängigkeit der von dem Sensor 10 erfassten Einbaulage der Systemeinheit 1 im Schaltschrank die Drehzahl des Lüfters 7 entsprechend einstellt. Dazu übermitteln die Sensoren 9, 10 einem Regler 12 der Regelung 11 die Temperatur und die Einbaulage repräsentierende Signale (Figur 2), welche der Regler 12 verarbeitet. Entsprechend diesen Sensorsignalen erzeugt der Regler 12 ein pulsweitenmoduliertes Ansteuersignal 13 und führt dieses dem Lüfter 7 zur Drehzahleinstellung zu.

Für den Fall, dass die Systemeinheit 1 vertikal aufgestellt oder eingebaut wird, derart, dass Seite A der Systemeinheit 1 nach unten und Seite B der Systemeinheit 1 nach oben zeigt, stellt die Regelung 11 eine erste Drehzahl ein. Diese ist niedriger als eine zweite Drehzahl, welche die Regelung 11 für den Fall einstellt, dass die Systemeinheit 1 so aufgestellt wird, dass die Seite B nach unten und die Seite A nach oben zeigt; denn in diesem Fall ist eine höhere Lüfterleistung erforderlich, um die von den Bauelementen der Steckkarten 2 erzeugte Warmluft, welche sich vom Lüfter weg in Richtung der Seite A der Systemeinheit 1 bewegt, ausreichend abzukühlen. Im erstgenannten Fall dagegen bewegt sich die Warmluft im Wesentlichen in Richtung der Seite B der Systemeinheit, also in Richtung der vom Lüfter 7 angesaugten Kaltluft.

Für den Fall, dass die Systemeinheit 1 horizontal aufgestellt oder eingebaut wird, stellt die Regelung 11 eine dritte Lüfterdrehzahl ein, welche höher als die erste aber niedriger als die zweite Drehzahl ist.

Wie hoch die jeweiligen Lüfterdrehzahlen in Abhängigkeit der Einbaulage und der Temperatur zu wählen sind, um jeweils eine gute Entwärmung bzw. gute Kühlung zu gewährleisten, wird z. B. im Rahmen einer Werkseinstellung ermittelt. Dort wird eine Vielzahl von Kennlinien aufgezeichnet, welche für unterschiedliche Einbaulagen die Abhängigkeit der Drehzahl von der Temperatur anzeigen. Für die jeweilige Einbaulage und die jeweilige Temperatur wird die Drehzahl eingestellt, die erforderlich ist, um eine gute Kühlung zu erzielen. Diese Kennlinien werden im Regler 12 hinterlegt, wobei während des Rechnerbetriebs vor Ort die Drehzahl eingestellt wird, die aufgrund der aktuell erfassten Einbaulage aus der dieser Einbaulage zugeordneten Kennlinie bei der aktuell erfassten Temperatur ausgelesen wird.

## Patentansprüche

1. Systemeinheit für einen Rechner, mit mindestens einer mit Bauelementen versehenen Steckkarte (2) und mit einem Lüfter (7) zur Kühlung der Bauelemente, wobei die Systemeinheit (1) ferner mit einer Regelung (11) zum Einstellen der Lüfterdrehzahl in Abhängigkeit von einem Signal eines Temperatursensors (9) und in Abhängigkeit einer Lage der Systemeinheit (1) versehen ist (1), **dadurch gekennzeichnet dass**,
- ein Lagesensor (10) die Lage der Systemeinheit (1) in einem Einbauschrank oder die Lage der Systemeinheit (1) an einem Aufstellort der Systemeinheit (1) erfasst,
- die Regelung (11)
- eine erste Lüfterdrehzahl für den Fall einstellt, dass die Systemeinheit (1) vertikal derart aufgestellt oder eingebaut ist, dass eine Seite der Systemeinheit (1) nach unten und eine zu dieser Seite gegenüberliegenden Seite der Systemeinheit (1) nach oben zeigt, und
- eine zweite Lüfterdrehzahl für den Fall einstellt, dass die Systemeinheit (1) vertikal derart aufgestellt oder eingebaut ist, dass die eine Seite der Systemeinheit (1) nach oben und die dieser Seite gegenüberliegenden Seite der Systemeinheit (1) nach unten zeigt.

## Claims

1. System unit for a computer, having at least one plug-in card (2) provided with components and having a ventilator (7) for cooling the components, wherein the system unit (1) is also provided with a controller (11) for setting the ventilator speed as a function of a signal of a temperature sensor (9) and as a function of a position of the system unit (1), **characterised in that**
- a position sensor (10) detects the position of the system unit (1) in a built-in cabinet or the position of the system unit (1) on an installation location of the system unit (1),
- the controller (11)
o sets a first ventilator speed in the event that the system unit (1) is installed or built in vertically such that one side of the system unit (1) points downwards and one side of the system unit (1) which is opposite said side points upwards, and
o sets a second ventilator speed in the event that the system unit (1) is installed or built in vertically such that the one side of the system unit (1) points upwards and the side of the system unit (1) which is opposite said side points downwards.

## Revendications

1. Unité de système pour un ordinateur, comprenant au moins une carte ( 2 ) à enficher pourvue de composants et comprenant un ventilateur ( 7 ) de refroidissement des composants, l'unité ( 1 ) de système étant pourvue, en outre, d'une régulation ( 11 ), pour régler la vitesse de rotation du ventilateur en fonction d'un signal d'une sonde ( 9 ) de température et en fonction d'une position de l'unité ( 1 ) de système, **caractérisée en ce que**
- un capteur ( 10 ) de position détecte la position de l'unité ( 1 ) de système dans une armoire de montage ou la position de l'unité ( 1 ) de système sur un lieu d'installation de l'unité ( 1 ) de système,
- la régulation ( 11 )
- règle la vitesse de rotation du ventilateur, dans le cas où l'unité ( 1 ) de système est érigée ou est montée verticalement, de manière à ce qu'un côté de l'unité ( 1 ) de système soit dirigé vers le bas et qu'un côté, opposé à ce côté, de l'unité ( 1 ) de système soit dirigé vers le haut et
- règle une deuxième vitesse de rotation du ventilateur, dans le cas où l'unité ( 1 ) de système est érigée ou est montée verticalement, de manière à ce que le un côté de l'unité ( 1 ) de système soit dirigé vers le haut et le côté, opposé à ce côté, de l'unité ( 1 ) de système soit dirigé vers le bas.
